# EUROPÄISCHE PATENTSCHRIFT

(11) **EP 0 292 013 B1**
(45) Veröffentlichungstag und Bekanntmachung des Hinweises auf die Patenterteilung: **02.02.1994**
(21) Anmeldenummer: 88108160.8
(22) Anmeldetag: 20.05.1988
(51) Int. Cl.: H01S 3/25, H01S 3/18

(54) **Laserdiodenarray mit lateraler Verkopplung**
Laser diode array with lateral coupling
Assemblage de diode laser avec accouplement latéral

(30) Priorität: 22.05.1987 DE 3717383
(43) Veröffentlichungstag der Anmeldung: 23.11.1988
(73) Patentinhaber: SIEMENS AKTIENGESELLSCHAFT, 80333 München (DE)
(72) Erfinder: Kappeler, Franz, Dr., D-8039 Puchheim (DE); Wolf, Thomas, D-8000 München 83 (DE); Stegmüller, Bernhard, Dr., D-8900 Augsburg (DE)

(56) Entgegenhaltungen:
- DE-A- 3 611 167
- DE-A- 3 630 212
- GB-A- 2 169 134
- GB-A- 2 187 330
- US-A- 4 352 187
- US-A- 4 531 217

## Beschreibung

Gegenstand der vorliegenden Erfindung ist ein Laserdiodenarray mit lateraler Verkopplung nach dem Oberbegriff des Anspruches 1.

Ein derartiges Laser diodenarray ist aus DE-A-3630212 bekannt.

Das Arbeitsprinzip des Lasers beruht im wesentlichen darauf, daß die in einem aktiven Bereich erzeugte Strahlung wegen Resonanz nur für gewisse Frequenzen verstärkt wird. Die Oberflächen an den Enden der zumeist streifenförmig ausgebildeten laseraktiven Bereiche wirken als teildurchlässige Spiegel. Wenn die Längenausdehnung ihres aktiven Bereiches einer ganzen Anzahl von halben Wellenlängen entspricht, tritt Resonanz auf. Eine Einfrequenz-Laserdiode kann z.B. dadurch hergestellt werden, daß statt nur eines laseraktiven Bereiches deren mehrere vorhanden sind, die untereinander verkoppelt werden.

Bei indexgeführten Lasern wird die Lokalisierung des Strahlungsfeldes auf laseraktive Streifen mittels einer Änderung des Brechungsindex bewirkt. Bei diesen indexgeführten Lasern klingen die Feldintensitäten außerhalb der aktiven Schicht sehr rasch ab. Mit einer geeigneten Schichtstruktur lassen sich bei diesem Typ von Halbleiterlasern die seitlichen Abstrahlungsverluste niedrig halten. Eine Verkopplung der verschiedenen laseraktiven Streifen ist allerdings erschwert.

In der deutschen Patentanmeldung P 37 06 477.0 ist eine Halbleiterlaseranordnung mit Index- oder Quasiindexführung beschrieben, bei der die laterale Verkopplung durch eine stückweise Aufhebung der Indexführung bewerkstelligt ist. Diese vollständige, aber nur stückweise Aufhebung der elektromagnetischen Isolation der laseraktiven Streifen untereinander hat den Nachteil, daß der Aufbau der verschiedenen Resonatoren nicht homogen genug ist.

In der deutschen Anmeldung P 37 08 666.9 ist eine Laseranordnung mit getrennt ansteuerbaren gekoppelten Halbleiterlasern beschrieben. Bei diesen Lasern liegt ebenfalls Indexführung für das Strahlungsfeld vor. Die Verkopplung besteht hierbei in vertikaler Richtung, so daß durch die Indexführung des umliegenden Halbleitermaterials eine starke Lokalisierung der Strahlung auf die laseraktiven Streifen gewährleistet ist. Bei dieser Anordnung ist die Schichtstruktur aufwendiger als bei lateral verkoppelten Halbleiterlaserarrays.

Aufgabe der vorliegenden Erfindung ist es, ein in möglichst wenigen Prozeßschritten herstellbares Laserdiodenarray mit lateraler Verkopplung anzugeben, bei dem die Abstrahlungsverluste an den Außenseiten möglichst gering sind.

Diese Aufgabe wird bei einem erfindungsgemäßen Bauelement durch die Merkmale des Anspruches 1 gelöst.

Die durch die vorliegende Erfindung erbrachte Lösung besteht darin, zwischen jeweils zwei laseraktiven Streifen eines index-oder quasiindexgeführten Laserdiodenarrays eine jeweils vorgegebene, im Vergleich zu der bei Einzellasern realisierten schwache Wellenführung vorzusehen. Die Geometrie des Aufbaues entspricht im wesentlichen der eines MCRW-Lasers.

Auf einem Substrat aus dotiertem III-V-Halbleitermaterial des ersten Leitungstyps (in der Regel n-Dotierung) sind eine als aktive Schicht für die Laserstreifen bestimmte, in der Regel undotierte, Schicht und darauf dotiertes Halbleitermaterial des zweiten Leitungstyps (in der Regel p-Dotierung) als Deckschicht aufgebracht. In dieser Deckschicht sind parallel zueinander verlaufende Stege ausgebildet, unter denen nach dem MCRW-Prinzip die Strahlung lokalisiert ist. Bei einem erfindungsgemäßen Aufbau ist die Dicke der Deckschicht zwischen der aktiven Schicht und der mit den Stegen versehenen Oberfläche im Bereich zwischen den Stegen jeweils so groß, daß eine vorgegebene Verkopplung zwischen jeweils zwei parallel nebeneinander verlaufenden Stegen gewährleistet ist.

Das Besondere an der vorliegenden Erfindung ist, daß bei vorhandener Verkopplung der Laserstreifen untereinander Vorkehrungen getroffen sind, die Abstrahlungsverluste nach außen, d.h. jeweils von den äußeren Stegen zum Rand hin, gering zu halten. Das kann dadurch geschehen, daß nach außen eine sehr starke Quasiindexführung bewirkt wird. Zu diesem Zweck ist die Dicke der Deckschicht zwischen der aktiven Schicht und der Oberfläche des Bauteiles so gering gehalten (maximal 0,3 µm), daß zusammen mit einer auf dem Halbleitermaterial in dem besagten Bereich aufgebrachten Oxidschicht die beabsichtigte Wellenführung erzielt wird. Alternativ hierzu kann ein erfindungsgemäßer Aufbau eine Lokalisierung des Strahlungsfeldes auf den von den Stegen eingenommenen Bereich dadurch sicherstellen, daß nach dem BH-Prinzip die aktive Schicht zu den Seiten hin begrenzt ist, so daß auch lateral Indexführung vorliegt. Das Halbleitermaterial der Deckschicht kann dann nach außen hin die volle Schichtdicke der Stege 3a, 3b, 3c aufweisen.

Im Bereich zwischen den Stegen kann auf der Deckschicht ebenfalls jeweils eine Oxidschicht aufgebracht sein. Die Dicke des Halbleitermaterials der Deckschicht zwischen der aktiven Schicht und der Oberfläche bzw. der jeweiligen Oxidschicht liegt im Bereich von etwa 0,4 µm bis 0,8 µm. Wenn eine Oxidschicht, d.h. ein elektrischer Isolator, aufgebracht ist, ist der effektive Brechungsindexsprung niedriger als bei direkter Metallisierung. Daher ist die Verkopplung bei der Ausführung mit Oxidschicht stärker, so daß die Dicke des Halbleitermaterials der Deckschicht im Bereich zwischen den Stegen bei gleichem geforderten Kopplungsgrad geringer zu halten ist als bei Ausführungen ohne Oxidschicht. Die Stege werden getrennt kontaktiert und auf der freien Seite des Substrates ein Gegenkontakt angebracht.

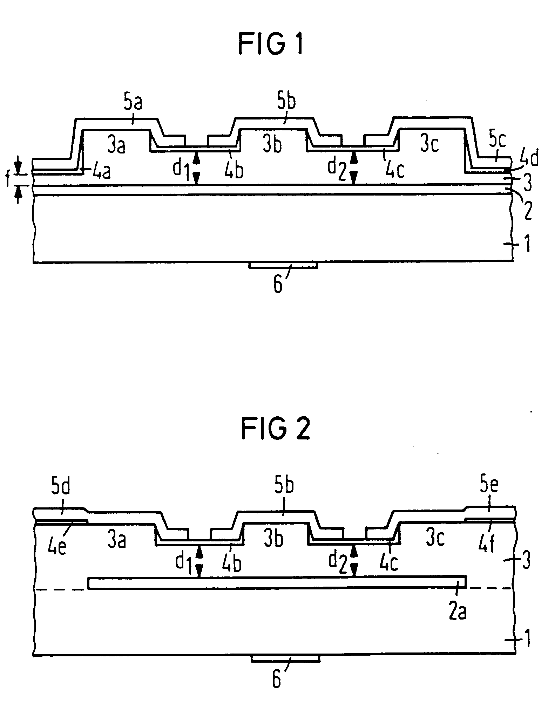

Es folgt die Beschreibung zweier Ausführungsbeispiele anhand der Figuren 1 und 2.
- Figur 1: zeigt einen quer zur Längsrichtung der Stege verlaufenden Schnitt durch ein erfindungsgemäßes Laserdiodenarray mit Wellenführung nach dem MCRW-Prinzip.
- Figur 2: zeigt einen quer zur Längsrichtung der Stege verlaufenden Schnitt durch ein erfindungsgemäßes Laserdiodenarray mit Wellenführung nach dem BH-Prinzip.

In Figur 1 ist ein Aufbau dargestellt, bei dem die außenseitliche Wellenführung nach dem MCRW-Prinzip durch einen Quasiindexsprung bewirkt wird. Auf dem Substrat 1 aus InP sind die aktive Schicht 2 aus InGaAsP mit der Dicke von etwa 0,15 µm und darauf die Deckschicht 3 aus InP aufgewachsen. In dieser Deckschicht 3 sind Stege 3a, 3b, 3c ausgebildet. Zwischen den Oberkanten jeweils zweier aufeinanderfolgender Stege 3a, 3b, 3c und zwischen den jeweils äußeren Oberkanten der äußeren Stege 3a, 3c und den Rändern des Bauelementes sind jeweils Oxidschichten 4a, 4b, 4c, 4d aufgebracht. Auf den Stegen 3a, 3b, 3c sind jeweils die angrenzenden Oxidschichten 4a, 4b, 4c, 4d teilweise mit überdeckende Kontakte 5a, 5b, 5c aufgebracht, die untereinander jeweils getrennt und somit auch getrennt elektrisch anschließbar sind. Die Dicken d₁, d₂ der Deckschicht 3 im Bereich zwischen den Stegen 3a, 3b, 3c betragen bei dem vorliegenden Ausführungsbeispiel beide 0,6 µm. Die Deckschicht 3 besitzt in den Bereichen außerhalb der jeweils äußeren Stege 3a, 3c zum Rand hin die Dicke f von 0,2 µm. Die Breite der Stege 3a, 3b, 3c beträgt jeweils 2 µm, der Abstand der Mittellinien jeweils 5 µm, was den üblichen Abmessungen im Stand der Technik entspricht. Dieses Laserdiodenarray ist für Emission der Wellenlänge 1,3 µm konzipiert. Auf der freien Seite des Substrates 1 ist der Gegenkontakt 6 aufgebracht.

Der Aufbau nach Fig. 2 unterscheidet sich demgegenüber dadurch, daß die aktive Schicht 2a nach außen hin begrenzt ist, so daß durch den lateralen Indexsprung eine Lokalisierung des Strahlungsfeldes auf den unter den Stegen 3a, 3b, 3c und deren Zwischenräumen liegenden Bereich besteht (BH-Struktur mit Indexführung). In der ebenen Verlängerung der aktiven Schicht 2a zum Rand hin verläuft die Grenze zwischen dem Substrat 1 und der Deckschicht 3, d.h. die Grenze zwischen den beiden verschiedenen Leitungstypen des dotierten Halbleitermaterials. Zwischen den Oberkanten jeweils zweier benachbarter Stege 3a, 3b, 3c und zwischen den jeweils äußeren Oberkanten der äußeren Stege 3a, 3c und den Rändern des Bauelementes sind jeweils Oxidschichten 4b, 4c, 4e, 4f aufgebracht. Auf den Stegen 3a, 3b, 3c sind jeweils die angrenzenden Oxidschichten 4b, 4c, 4e, 4f teilweise mit überdeckende Kontakte 5b, 5d, 5e aufgebracht, die untereinander jeweils getrennt und somit auch getrennt elektrisch anschließbar sind. Auf der freien Seite des Substrates 1 befindet sich der Gegenkontakt 6.

## Patentansprüche

1. Laserdiodenarray mit lateraler Verkopplung mit einem Substrat (1) aus dotiertem Halbleitermaterial des ersten Leitungstyps, mit einer aktiven Schicht (2,2a), mit einer Deckschicht (3) aus dotiertem Halbleitermaterial des zweiten Leitungstyps, mit mindestens zwei jeweils einem Laserstreifen zuzuordnenden in der Deckschicht (3) ausgebildeten Stegen (3a,3b,3c), wobei die Deckschicht (3) im Bereich zwischen jeweils zwei aufeinanderfolgenden Stegen (3a, 3b, 3c) eine jeweils so große Dicke (d₁, d₂) aufweist, daß eine laterale Verkopplung der Laserstreifen in geforderter Stärke bewirkt ist, mit jeweils einem Kontakt (5a,5b,5c;5b,5d,5e) auf jedem Steg (3a,3b,3c) und mit einem Gegenkontakt (6) auf der freien Oberfläche des Substrates (1),
**dadurch gekennzeichnet,**
- daß zum Zwecke getrennter Ansteuerbarkeit die Kontakte (5a, 5b,5c;5b,5d,5e) zwischen den jeweiligen Stegen (3a,3b,3c) unterbrochen sind,
- daß Oxidschichten (4a,4d;4e,4f) auf der Deckschicht (3) im Bereich zwischen den äußeren Oberkanten der äußeren Stege (3a,3c) und den Rändern des Bauelementes aufgebracht sind, und
- daß die Schichtstruktur des Bauelementes außerhalb des von den Stegen (3a,3b,3c) und deren Zwischenräumen eingenommenen Bereiches, verschieden ist von der Schichtstruktur zwischen jeweils zwei aufeinanderfolgenden Stegen und so beschaffen ist, daß an den Seiten des Arrays eine vorgegeben starke Wellenführung realisiert ist.

2. Laserdiodenarray nach Anspruch 1,
**dadurch gekennzeichnet,**
daß auf der Deckschicht (3) zwischen den oberen Kanten benachbarter Stege (3a,3b,3c) weitere Oxidschichten (4b,4c) aufgebracht sind.

3. Laserdiodenarray nach Anspruch 1 oder 2,
**dadurch gekennzeichnet,**
daß die für die Verkopplung bemessenen Dicken (d₁,d₂ ) der Deckschicht (3) im Bereich zwischen jeweils zwei benachbarten Stegen (3a,3b,3c) im Bereich von 0,4 µm bis 0,8 µm liegen.

4. Laserdiodenarray nach einem der Ansprüche 1 bis 3 mit auf dem Substrat (1) ganzflächig aufgewachsener aktiver Schicht (2) und mit darauf befindlicher Deckschicht (3), in der die Stege (3a,3b,3c) ausgebildet sind,
**dadurch gekennzeichnet,**
daß die Deckschicht (3) in dem an die äußeren Stege (3a,3c) jeweils zum Rand der Deckschicht (3) hin angrenzenden Bereich eine gegenüber dem Bereich zwischen den Stegen (3a,3b,3c) derart verminderte Dicke (f) aufweist, daß die vorgegebene Wellenführung an den Seiten des Arrays vorliegt.

5. Laserdiodenarray nach einem der Ansprüche 1 bis 3,
**dadurch gekennzeichnet,**
daß die aktive Schicht (2a) im Bereich der Stege (3a,3b,3c) und deren Zwischenräume ausgebildet ist und zum Rand des Bauelementes hin derart begrenzt ist, daß die vorgegebene starke Wellenführung an den Seiten des Arrays bewirkt ist (BH-Struktur).

6. Laserdiodenarray nach Anspruch 4,
**dadurch gekennzeichnet,**
daß die verminderte Dicke (f) der Deckschicht (3) in dem an die äußeren Stege (3a,3c) jeweils zum Rand der Deckschicht (3) hin angrenzenden Bereich maximal 0,3 µm beträgt.

7. Laserdiodenarray nach einem der Ansprüche 1 bis 6,
**dadurch gekennzeichnet,**
daß das Halbleitermaterial zwischen der aktiven Schicht (2;2a) und der zwischen den Stegen (3a,3b,3c) befindlichen Oberfläche jeweils dieselbe Dicke (d₁,d₂) aufweist (d₁ = d₂).

## Claims

1. Laser diode array with lateral coupling, having a substrate (1) of doped semiconductor material of a first conductive type, having an active layer (2, 2a), having a cover layer (3) of doped semiconductor material of a second conductive type, having at least two ridges (3a, 3b, 3c) which are to be allocated in each instance to a laser stripe and which are formed in the cover layer (3), the cover layer (3) exhibiting in the region between in each instance two successive ridges (3a, 3b, 3c), a thickness (d₁, d₂) which is in each instance of such magnitude that a lateral coupling of the laser stripes in the required intensity is effected, having in each instance one contact (5a, 5b, 5c; 5b, 5d, 5e) on each ridge (3a, 3b, 3c) and having a countercontact (6) on the free surface of the substrate (1), characterized in that
- for the purpose of separate drivability, the contacts (5a, 5b, 5c; 5b, 5d, 5e) are interrupted between the respective ridges (3a, 3b, 3c),
- in that oxide layers (4a, 4d; 4e, 4f) are applied to the cover layer (3) in the region between the outer upper edges of the outer ridges (3a, 3c) and the edges of the component, and
- in that the layer structure of the component outside the region occupied by the ridges (3a, 3b, 3c) and their intermediate spaces is different from the layer structure between in each instance two successive ridges and is of such a nature that a waveguidance of predetermined intensity is effected at the sides of the array.

2. Laser diode array according to Claim 1, characterized in that further oxide layers (4b, 4c) are applied to the cover layer (3) between the upper edges of adjacent ridges (3a, 3b, 3c).

3. Laser diode array according to Claim 1 or 2, characterized in that the thicknesses (d₁, d₂) of the cover layer (3), which are dimensioned for the coupling, are in the range from 0.4 µm to 0.8 µm in the region between in each instance two adjacent ridges (3a, 3b, 3c).

4. Laser diode array according to one of Claims 1 to 3 having an active layer (2) grown over the entire surface of the substrate (1) and having a cover layer (3) which is situated thereon and in which the ridges (3a, 3b, 3c) are formed, characterized in that the cover layer (3) exhibits, in the region adjoining the outer ridges (3a, 3c) in each instance towards the edge of the cover layer (3), a thickness (f) which is reduced in relation to the region between the ridges (3a, 3b, 3c) in such a manner that the predetermined waveguidance is present at the sides of the array.

5. Laser diode array according to one of Claims 1 to 3, characterized in that the active layer (2a) is provided in the region of the ridges (3a, 3b, 3c) and their intermediate spaces, and is bounded towards the edge of the component in such a manner that the predetermined intense waveguidance is effected at the sides of the array (BH structure).

6. Laser diode array according to Claim 4, characterized in that the reduced thickness (f) of the cover layer (3) is at most 0.3 µm in the region adjoining the outer ridges (3a, 3c) in each instance towards the edge of the cover layer (3).

7. Laser diode array according to one of Claims 1 to 6, characterized in that the semiconductor material exhibits in each instance the same thickness (d₁, d₂) (d₁ = d₂) between the active layer (2; 2a) and the surface situated between the ridges (3a, 3b, 3c).

## Revendications

1. Réseau de diodes laser à couplage latéral, comportant un substrat (1) formé d'un matériau semiconducteur dopé possédant le premier type de conduction, une couche active (2,2a), une couche de revêtement (3) formée d'un matériau semiconducteur dopé possédant le second type de conduction, au moins deux barrettes (3a,3b,3c), qui doivent être respectivement associées à une bande du laser et sont formées dans la couche de revêtement (3), la couche de revêtement (3) possédant, dans la zone située entre respectivement deux barrettes successives (3a,3b,3c), une épaisseur (d₁,d₂) respectivement suffisamment grande pour réaliser un couplage latéral des bandes du laser avec l'intensité requise,
et comportant respectivement un contact (5a,5b,5c; 5b,5d,5e) situé sur chaque barrette (3a,3b,3c) et un contact antagoniste (6) situé sur la surface dégagée du substrat (1), caractérisé par le fait
- que pour avoir une capacité de commande séparée, les contacts (5a,5b,5c;5b,5d,5e) sont interrompus entre les barrettes respectives (3a,3b,3c),
- des couches d'oxyde (4a,4d;4e,4f) sont disposées sur la couche de revêtement (3), dans la zone située entre les bords supérieurs extérieurs des barrettes extérieures (3a,3c) et les bords du composant, et
- que la structure en couches du composant à l'extérieur de la zone occupée par les barrettes (3a,3b,3c) et par leurs espaces intercalaires est différente de la structure en couches présente entre respectivement deux barrettes successives et est agencée de telle sorte qu'un guidage d'une intensité prédéterminée des ondes est réalisé sur les deux côtés du réseau.

2. Réseau de diodes laser suivant la revendication 1, caractérisé par le fait que d'autres couches d'oxyde (4b,4c) sont déposées sur la couche de revêtement (3), entre les bords supérieurs de barrettes voisines (3a,3b,3c).

3. Réseau de diodes laser suivant la revendication 1 ou 2, caractérisé par le fait que les épaisseurs (d₁,d₂), dimensionnées pour le couplage, de la couche de revêtement (3) se situent, dans la zone présente entre respectivement deux barrettes voisines (3a,3b,3c), dans la gamme allant de 0,4 mm à 0,8 mm.

4. Réseau de diodes laser suivant l'une des revendications 1 à 3, comportant une couche active (2) formée par croissance sur toute la surface du substrat, et une couche de revêtement (3) située sur cette couche active et dans laquelle sont formées les barrettes (3a,3b,3c), caractérisé par le fait que la couche de revêtement (3) possède, dans la zone qui jouxte les barrettes extérieures (3a,3c) respectivement en direction du bord de la couche de revêtement (3), une épaisseur (f) qui est réduite par rapport à la zone située entre les barrettes (3a,3b,3c) de telle sorte que le guidage prédéterminé des ondes intervient sur les deux côtés du réseau.

5. Réseau de diodes laser suivant l'une des revendications 1 à 3, caractérisé par le fait que la couche active (2a) est formée dans la zone des barrettes (3a,3b,3c) et de leurs espaces intercalaires et est limitée en direction du bord du composant de telle sorte que le guidage intense prédéterminé des ondes est réalisé sur les côtés du réseau (structure BH).

6. Réseau de diodes laser suivant la revendication 4, caractérisé par le fait que l'épaisseur réduite (f) de la couche de revêtement (3) est égale au maximum à 0,3 mm dans la zone qui jouxte les barrettes extérieures (3a,3c) respectivement en direction du bord de la couche de revêtement (3).

7. Réseau de diodes laser suivant l'une des revendications 1 à 6, caractérisé par le fait que le matériau semiconducteur entre la couche active (2;2a) et la surface située entre les barrettes (3a,3b,3c) possède respectivement une épaisseur (d₁,d₂) constante (d₁ = d₂).
